# EUROPEAN PATENT APPLICATION

(11) **EP 0 658 929 A1**
(43) Date of publication of application: **21.06.1995**
(21) Application number: 94119983.8
(22) Date of filing: 16.12.1994
(51) Int. Cl.: H01L 21/68, H01L 23/538, H05K 3/46

(54) **Process for delaminating organic resin from board and process for manufacturating organic resin multi-layer wiring board**

(30) Priority: 16.12.1993 JP 316160/93; 28.12.1993 JP 334734/93; 29.12.1993 JP 355498/93
(71) Applicant: NEC CORPORATION, Tokyo (JP)
(72) Inventor: Tanaka, Shinji, c/o NEC Corporation, Tokyo (JP); Ishida, Hisashi, c/o NEC Corporation, Tokyo (JP); Hasegawa, Shinichi, c/o NEC Corporation, Tokyo (JP); Tamura, Koetsu, c/o NEC Corporation, Tokyo (JP)
(74) Representative: VOSSIUS & PARTNER

(57) **Abstract**

A process for delaminating an organic resin insulation layer and a board therefor without adversely affecting the organic resin multi-layer wiring layer. A polyimide insulation layer 121 is formed on a quartz glass board 111. On the polyimide insulation layer 121 are laminated another polyimide insulation layer and a wiring layer which form a first block 100 together with the polyimide insulation layer 121. Irradiation from an excimer laser on the back of the quartz glass board 111 is performed to delaminate the first block 100 and the quartz glass board 111. UV rays from the excimer laser 1 and the polyimide insulation layer 121 undergo a photochemical reaction to remove the polyimide insulation layer 121 located at the interface with the quartz glass board 111 and to delaminate the quartz glass board 111 from the first block 100.

## Description

The present invention relates to a process for delaminating an organic resin from a board. In addition, the present invention relates to a process for manufacturing an organic resin multi-layer wiring board, particularly to a process for manufacturing an organic resin multi-layer wiring board by connecting a plurality of blocks.

The process of delamination of organic resins from boards is carried out in a variety of situations during manufacturing of electronic parts. As an example, in a process for manufacturing a certain organic resin multi-layer wiring board, the organic resin is delaminated from the board. According to this manufacturing process, a plurality of separately manufactured blocks with wiring layers are connected to each other. The connected blocks are incorporated into a multi-layer wiring board. The blocks are organic resin multi-layer wiring layers. The blocks are laminated on a board. In preparation for connection, the blocks are delaminated from the boards. An instance of this manufacturing process is disclosed in Japanese Patent Koukai Hei No. 5-206643. The technique described in this gazette dissolves the board for separation of the block and the board. More specifically, an aluminum board is dissolved in an aqueous solution of hydrochloric acid. This delaminating technique is, however, troublesome in that an aqueous solution of hydrochloric acid deteriorates the organic resin multi-layer wiring layer.

An object of the present invention is to provide a process for delaminating an organic resin which does not adversely affect portions other than the portion to be delaminated.

A further object of the present invention is to provide a process for manufacturing an organic resin multi-layer wiring board with a high degree of reliability.

A still further object of the present invention is to provide a process for manufacturing an organic resin multi-layer wiring board for a shorter term.

The process for delaminating an organic resin according to the present invention causes a photochemical reaction of the organic resin to weaken the adhesive force between the organic resin and the board. Since the section of the organic resin which is in contact with the board is irradiated with light, it is necessary to use a board which transmits the light. The light applied to the board is transmitted through the board and reaches the organic resin.

More concretely, the process for delaminating an organic resin according to the present invention includes the following steps:
(A) A step of providing a first surface of a board with an organic resin. The organic resin undergoes a photochemical reaction by exposure to light. The board transmits the light.
(B) A step of applying light to a second surface of the board. The light is transmitted through the board and reaches the organic resin. The section of the organic resin which contacts with the board undergoes a photochemical reaction by exposure to the light. The photochemical reaction lowers the adhesive force between the organic resin and the board.

In the process for manufacturing an organic resin multi-layer wiring board according to the present invention, each block is delaminated from the board by the delaminating process mentioned above. More concretely, the process for manufacturing an organic resin multi-layer wiring board according to the present invention includes the following steps:
(A) A step of forming a first block on a first board. The first board transmits light. Step A includes the following steps:
   (a) A step of forming a first organic resin layer on the board. The first organic resin layer undergoes a photochemical reaction by exposure to light.
   (b) A step of alternatively laminating a wiring layer and an organic resin insulation layer on the first organic resin layer.
   (c) A step of laminating another first organic resin adhesive layer on the organic resin insulation layer or wiring layer arranged in Step (b).
(B) A step of forming a second block on a second board. Step B includes the following steps:
   (d) A step of alternatively laminating an organic resin insulation layer and a wiring layer on the second board.
   (e) A step of laminating a second organic resin adhesive layer on the organic resin insulation layer or the wiring layer formed in Step (d).
(C) A step of connecting the first block and the second block.
   Step C includes the following steps:
   (f) A step of facing the first organic resin adhesive layer of the first block to the second organic resin adhesive layer of the second block.
   (g) A step of heating and pressing the first block and the second block. The first organic resin adhesive layer adheres to the second organic resin adhesive layer.
(D) A step of delaminating the first block from the first board. Step D includes the following steps:
   (h) A step of light irradiation on the opposite side from the side of the first board which has the first organic resin layer. The light is transmitted through the first board and reaches the first organic resin layer. The section of the organic resin layer which adheres to the first board undergoes a photochemical reaction by exposure to the light. The photochemical reaction lowers the adhesive force between the first organic resin layer and the first board.
   (i) A step of delaminating the first block from the first board.

In the above manufacturing process, the first board may be removed prior to the connection between the first block and the second block. For this, however, the adhesion between the first block and the second block must be temporary.

Other objects, features and advantages of the present invention will become more apparent when the following description is read in conjunction with the accompanying drawings, wherein:
First 1 is a schematic view of Example 1 according to the present invention;
Figs. 2-7 show sectional views of a first block 100 in Steps 1-6 of Example 1, respectively;
Figs. 8-13 show sectional views of a second block 200 in Steps 7-12 of Example 1, respectively;
Fig. 14 shows a sectional view of a first block 100 and a second block 200 connected to each other in Step 13 of Example 1;
Figs. 15-17 illustrates a process for delaminating a quartz glass board in Example 1;
Figs. 18-20 show sectional views of a block laminate 1200 in Steps 17-19 of Example 1;
Fig. 21 shows a sectional view of a third block 300 and a block laminate 1200 connected to each other in Step 20 of Example 1;
Fig. 22 is a schematic view of Example 2 according to the present invention;
Fig. 23 shows sectional views of a first block 100 and a second block 200 connected to each other in Step 22 of Example 2;
Fig. 24(a) through Fig. 31(a) and Figs. 32-36 show sectional views of intermediate products in Steps 1-13 of Example 3 according to the present invention, respectively;
Fig. 24(b) through Fig. 31(b) show plan views of intermediate products in Steps 1-8 of Example 3, respectively; Fig. 37 is a sectional view of a multi-layer wiring board completed in Step 14 of Example 14;
Fig. 38(a) through Fig. 45(a) show sectional views of intermediate products in Steps 1-8 of Example 3, respectively;
Fig. 38(b) through Fig. 45(b) show plan views of intermediate products in Steps 1-8 of Example 3, respectively;
Fig. 46 through Fig. 49 show sectional views of intermediate products in Steps 15-19 of Example 3, respectively; and
Fig. 50 shows a sectional view of a multi-layer wiring board completed in Step 19 of Example 3.

In these figures, the same reference numerals depict the same parts, respectively.

### Examples

### Example 1

Example 1 of the present invention will now be described with reference to the accompanying drawings.

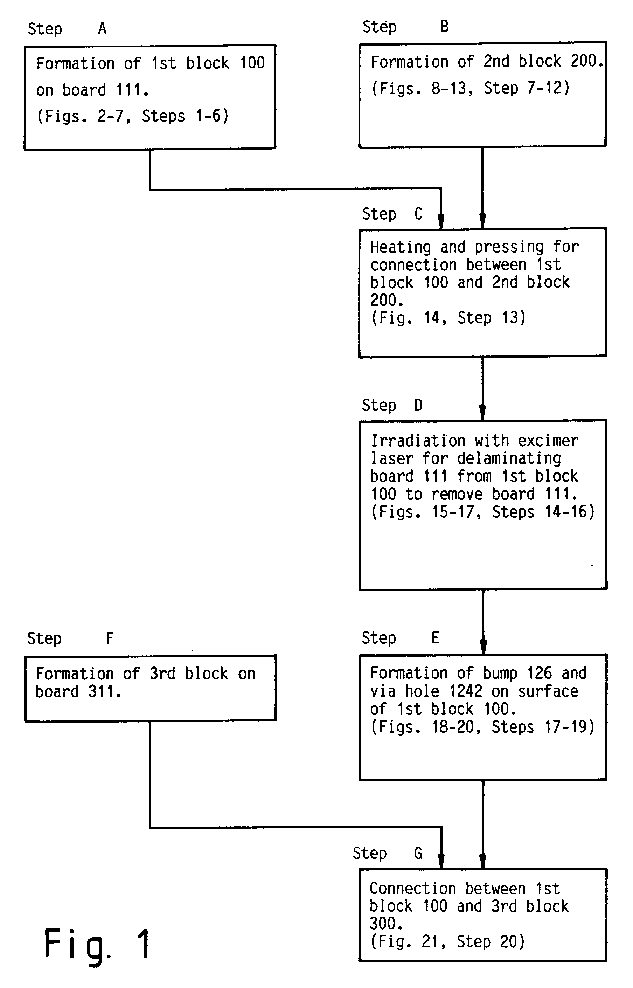

First, an outline of the manufacturing process of Example 1 will be described. Referring to Fig. 1, the manufacturing process of Example 1 includes Steps A-G. Of these steps, Step D is the step characteristic of the present invention.

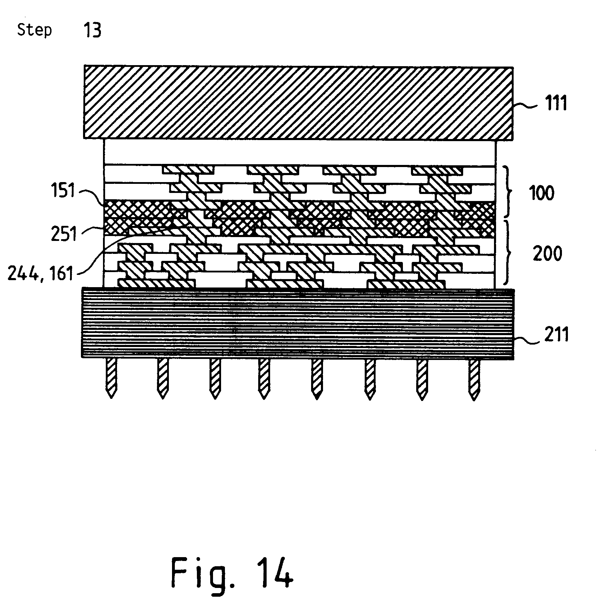

With reference to Figs. 1-7, in Step A, a block 100 is formed on a board 111. Step A includes Steps 1-6. Referring to Fig. 1 and Figs. 8-13, a block 200 is formed in Step B. Step B includes Steps 7-12. Steps A and B may be carried out in any order. Steps A and B may be conducted simultaneously. Referring to Fig. 1 and Fig. 14, in Step C, the first block 100 and the second block 200 are connected to each other by heating and pressing. Step C includes step 13.

Referring to Fig. 1 and Figs. 15-17, in Step D, excimer laser irradiation of the block 100 delaminates the block 100 from the board 111. This step is characteristic of the present invention. Step D includes Steps 14-16.

With reference to Fig. 1 and Figs. 18-20, in Step E, in order to connect the first block 100 with a third block, a bump 126 and a via hole 1242 are formed on the surface of the first block 100. Step E includes Steps 17-19.

Referring to Fig. 1, in Step F, a third block 300 is formed. Step F may be carried out any time. Step F may be carried out at the same time as Step A or B.

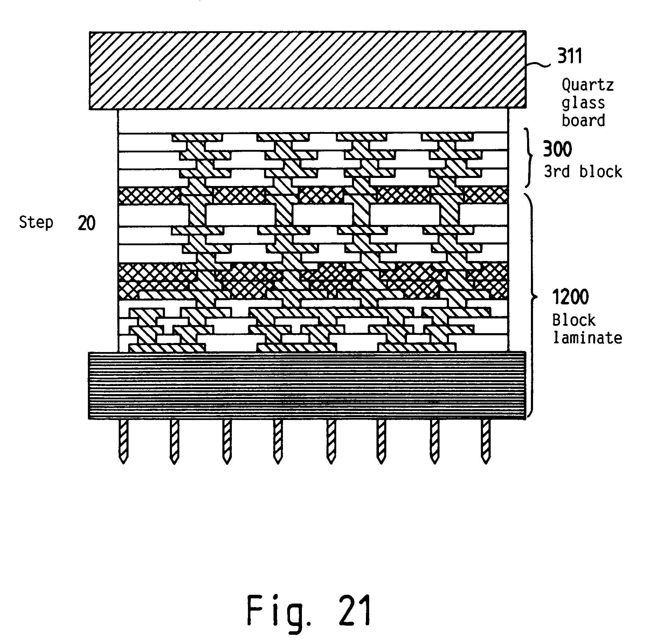

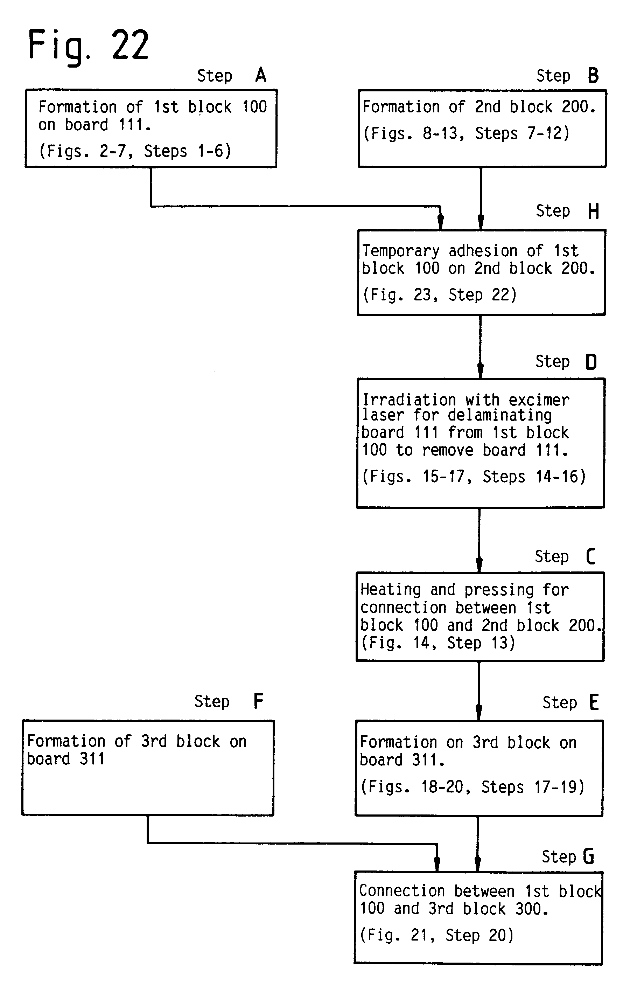

Referring to Fig. 1 and Fig. 21, in Step G, a connection is established between the first block 100 and the third block 800. Step G includes Step 20.

Next, an explanation will be made of Steps 1-21.

### Matters Common to Steps

First, an explanation will be given regarding matters common to all the steps.

In the organic resin multi-layer wiring board of the present example, a polyimide is used as the organic resin which composes the insulation layer. The thickness of the polyimide insulation layer is 20 µm. The film thickness of the wiring layer is 10 µm, and the wiring width of the wiring layer is 25 µm. In addition, the diameter of a via hole which connects the wiring layers is 100 µm. Unless otherwise specified, dimensions of the polyimide insulation layers, wiring layers and via holes to be formed in the present example conform to the above-mentioned.

In this connection, a photosensitive polyimide with a low coefficient of thermal expansion is used to form the polyimide isolation layer. Here, the "photosensitive polyimide with a low coefficient of thermal expansion" is defined to be a photosensitive polyimide whose coefficient of thermal expansion is 10-30 ppm. On the other hand, as the polyimide adhesive layer there is used a polyimide resin having a glass transition point.

The wiring layer and the bump is formed from gold. More concretely, they are formed by electrolytic palting of conductor patterns. The conductor patterns are formed by photolithographic techniques using photoresists.

### Step A

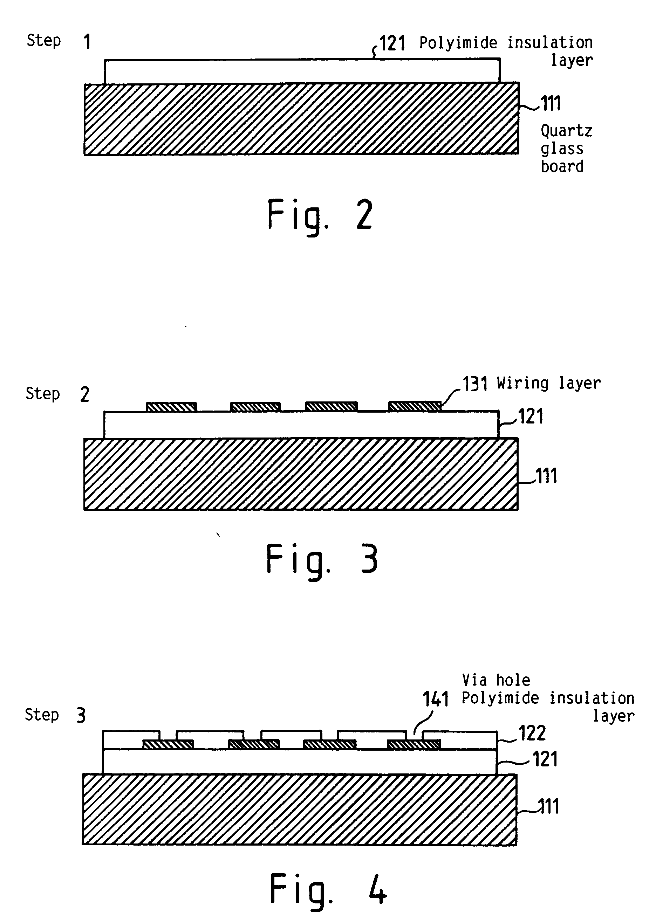

Referring to Fig. 2 through Fig. 7, in Step 1 through Step 6, a first block 100 is formed on a quartz glass board 111.

### Step 1

Referring to Fig. 2, in Step 1, a uniform polyimide insulation layer 121 is formed on the quartz glass board 111. The quartz glass board 111 has a thickness of 2 mm. In addition, the polyimide insulation layer 121 is formed using a photosensitive polyimide with a low coefficient of thermal expansion. The thickness of the polyimide insulation layer 121 is 10 µm.

### Step 2

Referring to Fig. 3, in Step 2, a wiring layer 131 is formed on a polyimide insulation layer 121. This wiring layer 131 is used for connection wiring, and also for wiring for ground connection.

### Step 3

Referring to Fig. 4, in Step 3, a polyimide insulation layer 122 is formed on the wiring layer 131. In the polyimide insulation layer 122 there is formed a via hole 141. The polyimide insulation layer 122 and the via hole 141 are formed in the following steps.

In the first step, varnish of a photosensitive polyimide with a low coeffient of thermal expansion is applied to a wiring layer 131.

In the second step, the applied polyimide varnish is exposed and developed to form a via hole 141 therein.

In the third step, the polyimide varnish with the via hole 141 formed therein is cured. The polyimide insulation layer 122 and the via hole 141 are formed in this manner. The polyimide insulation layer 122 has a thickness of 20 µm.

### Step 4

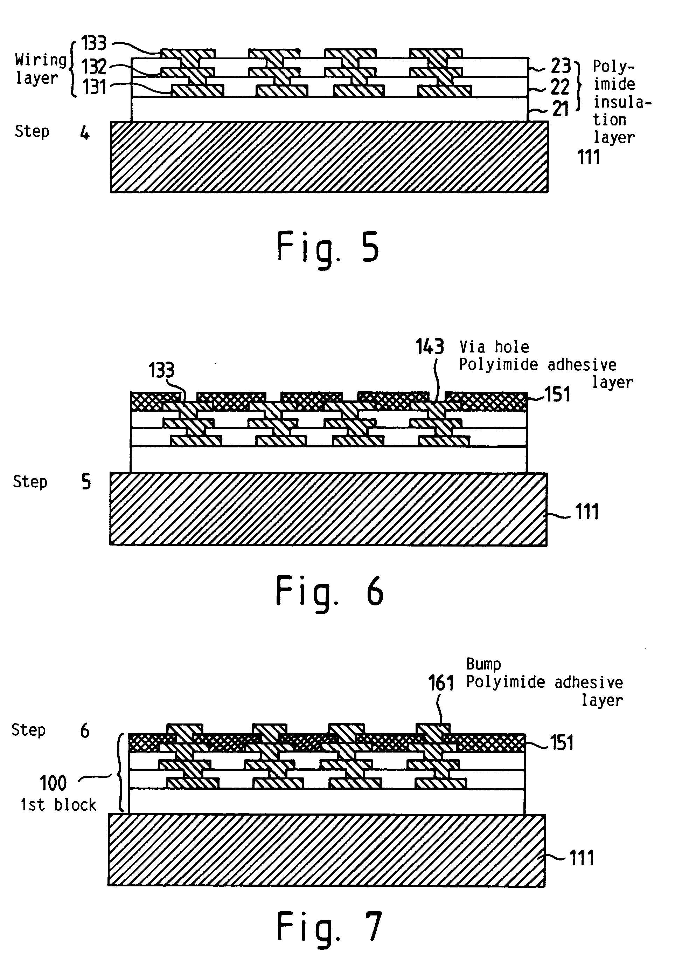

Referring to Fig. 5, in Step 4, a wiring layer 132, a polyimide insulation layer 123 and a wiring layer 133 are layered on a polyimide insulation layer 122 in that order. These layers are formed by carrying out the process of Step 2 and Step 3 repeatedly. These layers have the same measurements and quality of material as those formed in Step 2 and Step 3.

### Step 5

Referring to Fig. 6, in Step 5, a polyimide adhesive layer 151 and a via hole 143 are formed on the wiring layer 133. The polyimide adhesive layer 151 and the via hole 143 are formed in the following steps.

In the first step, polyimide varnish having a glass transition point is applied onto the wiring layer 133. This polyimide varnish forms a polyimide adhesive layer 151. That is, the polyimide adhesive layer 151 and the polyimide insulation layers 121-128 are different in the properties of the polyimides used.

In the second step, the applied polyimide varnish is subjected to exposure and development to form a via hole 143 therein.

In the third step, the polyimide varnish is cured. The polyimide adhesive layer 151 and the via hole 143 are formed in this manner. The polyimide adhesive layer 151 is 10 µm thick.

### Step 6

Referring to Fig. 7, in Step 6, a bump 161 is formed. The bump 161 connects a first block with a second block which are prepared in the steps described later. The bump 161 is connected to the wiring layer 133 through the via hole 143.

The bump 161 is formed by metal plating. The metal deposit consists of four skins. The materials of the first through fourth skins are nickel, gold, tin and gold, respectively. The first skin is located closest to the metal patterns. The first through fourth metal skins are 3 µm, 8 µm, 11 µm and 8 µm, respectively. The diameter of the bump 4111 is 100 µm. The weight ratio of the gold to tin is gold : tin = 4 : 1. During the later heating process, the second through fourth skins melt and mingle with the metal patterns. The first skin prevents the mixture of the second through fourth skins from diffusing into the metal patterns.

By following the process of Steps 1-6, a first block 100 is formed. In Step 4 of the present example, for instance, two wiring layers were layered. In the actual process, the first block 100 comprises more wiring layers.

### Step B

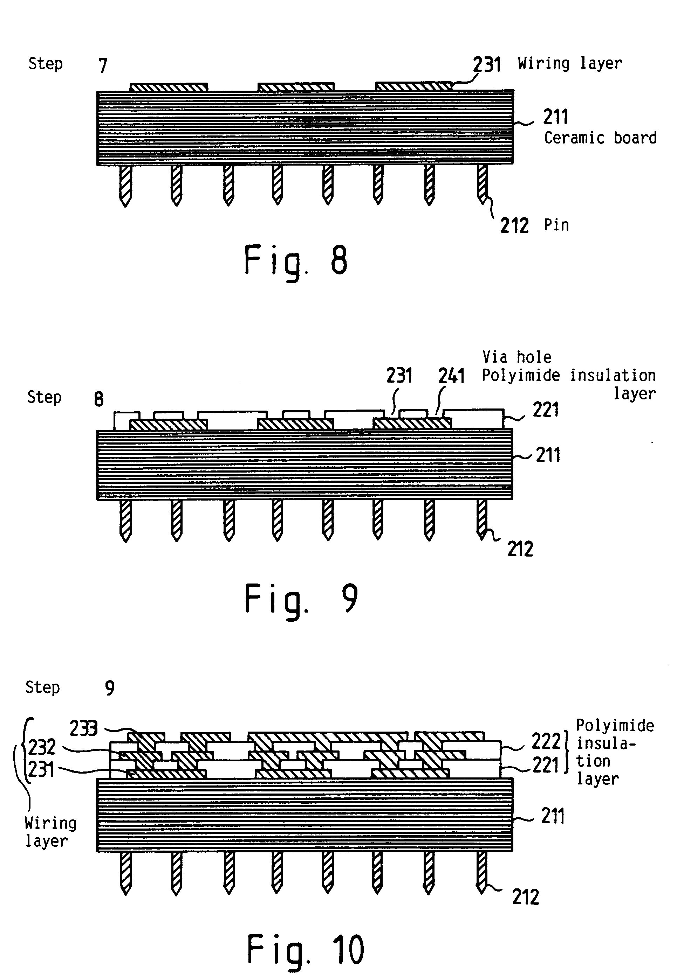

Referring to Fig. 8 through Fig. 13, in Step 7 through Step 13, a second block 200 is formed on a ceramic board 211.

### Step 7

Referring to Fig. 8, in Step 7, a wiring layer 231 is formed on a ceramic board 211.

The ceramic board 211 is equipped with a pin 212 on the opposite side from the side thereof which has the wiring layer 231. The pin 212 is connected to the wiring layer 231 through internal wiring of the ceramic board 211. After completion of the polyimide multi-layer wiring board, the pin 212 is used as an input/output signal pin and power source pin.

The wiring layer 231 is formed in the same manner as in Step 2. This wiring layer 231 is used for connection wiring, and further for wiring for ground connection.

### Step 8

Referring to Fig. 9, in Step 8, a polyimide insulation layer 221 is formed on the wiring layer 231. In the polyimide insulation layer 221, there is formed a via hole 241. The polyimide insulation layer 221 and the via hole 241 are formed in the same manner as in Step 3.

### Step 9

Referring to Fig. 10, in Drawing 9, on the polyimide insulation layer 221 there are formed a wiring layer 232, a polyimide insulation layer 222 and a wiring layer 233. These layers are formed in the same manner as in Step 4.

### Step 10

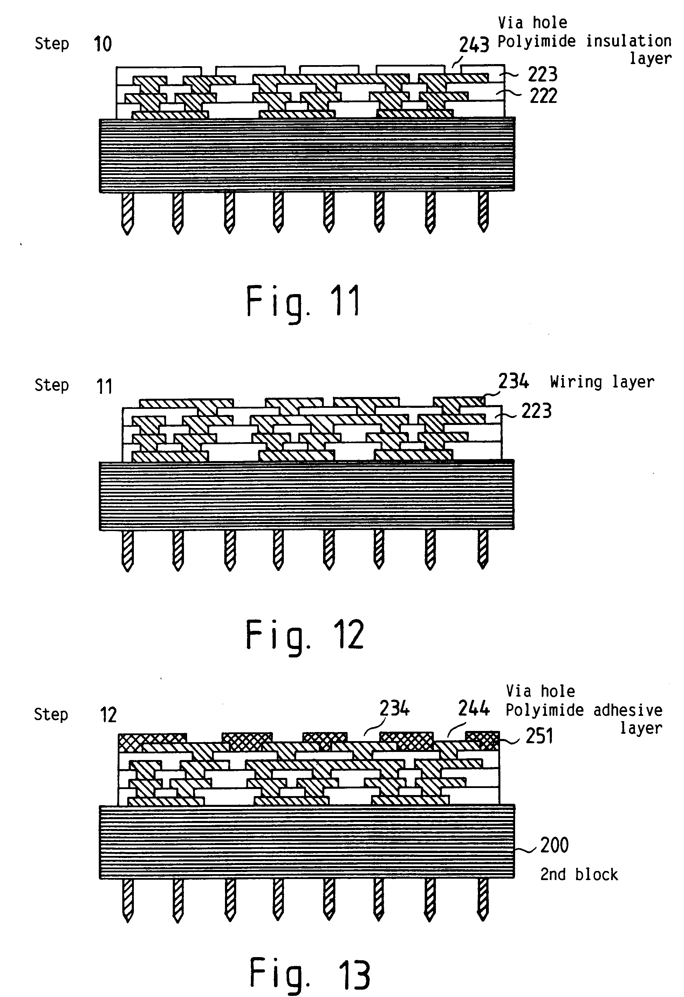

Referring to Fig. 11, in Step 10, a polyimide insulation layer 223 is formed on the polyimide insulation layer 222. In the polyimide insulation layer 223 is formed a via hole 243. The polyimide insulation layer 223 and the via hole 243 are formed in the same manner in Step 3.

### Step 11

Referring to Fig. 12, in Step 11, a wiring layer 234 in formed on the polyimide insulation layer 223. The wiring layer 234 is formed in the same manner as in Step 2.

### Step 12

Referring to 13, in Step 12, on the wiring layer 234 is formed a polyimide adhesive layer 251. The polyimide adhesive layer 251 is formed in the same manner as in Step 5. The polyimide adhesive layer 251 has the same thickness as in Step 5.

By following the process of Steps 6-12, a second block 200 is formed. In Steps 9-11 of the present example, three wiring layers are layered for simplicity of description. Actually, however, the second block 200 comprises more wiring layers.

### Step C

### Step 13

Referring to Fig. 14, in Step 13, a connection between the first block 100 and the second block 200 is established by heating and pressing. The connection between the first block 100 and the second block 200 is carried out in the following steps.

In the first step, positioning of the first block 100 is performed. That is, the first block 100 is positioned so that the bump 161 of the first block 100 is inserted in a counterpart via hole 244 of the second block 200.

In the second step, the first block 100 is mounted on the second block 200.

In the third step, the respective blocks are heated so that their temperatures exceed glass transition points of the polyimide adhesive layers 151 and 251. By this heating, the polyimide adhesive layer 151 and the polyimide adhesive layer 251 adhere to each other. As a result, the first block and the second block are assembled into one unit.

Also in this step, the bump 161 melts and connects with the wiring layer 234. In other words, the first block 100 and the second block 200 are electrically connected to each other. Concrete heating and pressing procedures are as follows. The heating and pressing process is carried out in an autoclave type vacuum pressing apparatus. "Mini-Bonder" of United Mcgill can be used as the autoclave type vacuum pressing appartatus. The pressing gas used is nitrogen gas. Heating temperature, applied pressure and heating and pressing time are 350°C, 14 kg/cm², and 60 seconds, respectively. During this heating and pressing process the board is mounted on a platen. The mounted board is sealed with a polyimide film to keep the inside in a vacuum condition. This condition allows the pressing to be performed uniformly. Here, the sealing with the polyimide film is performed by applying an adhesive member to the circumference of the platen, and sticking the circumference of the polyimide film to this adhesive member.

### Step D

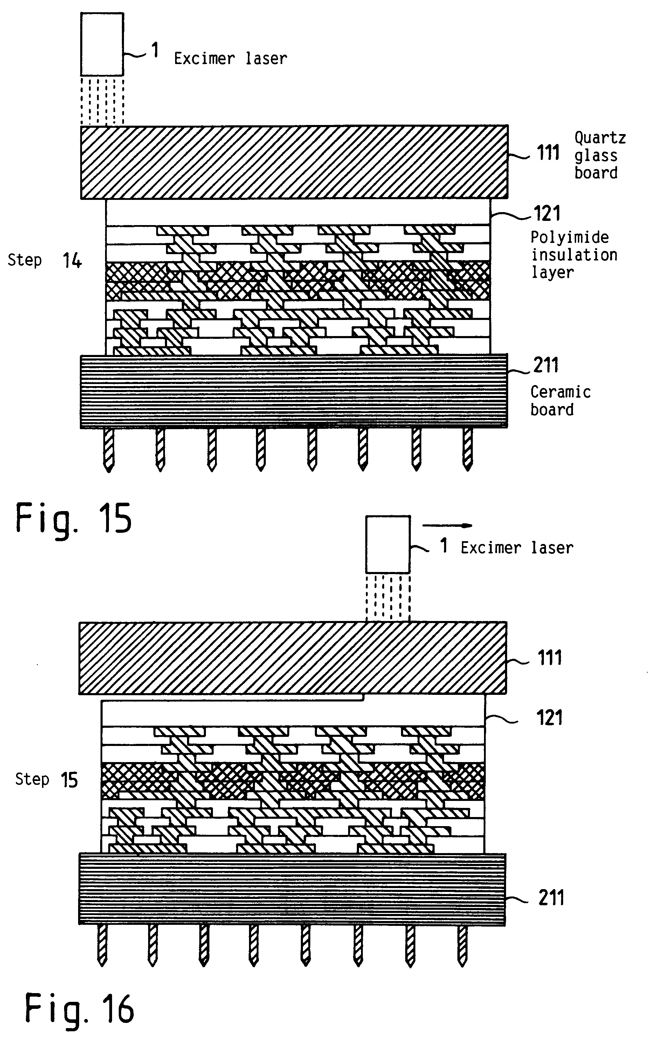

Referring to Figs. 15-17, in Steps 14-16, the board 111 is delaminated from the block 100.

### Step 14

Referring to Fig. 15, in Step 14, the quartz glass board 111 is irradiated with UV rays from an excimer laser 1. The present step comprises a characteristic aspect of the present invention.

Since the quartz glass board 111 is transparent, UV rays from the excimer laser 1 are transmitted through the quartz glass board 111 and reaches the polyimide insulation layer 121. The portion subjected to irradiation with UV rays undergoes a photochemical reaction. The portion subjected to the photochemical reaction is removed. This photochemical reaction will be discussed later. Since the section which has connected the block 100 and the quartz glass board 111 is removed, the quartz glass board 111 is delaminated from the polyimide insulation layer 121.

When krypton fluoride KrF is used as the laser gas, the excimer laser 1 at a wavelength of 248 nm, and an energy density of 0.8 J/cm² may remove the polyimide insulation layer 121 about 1 µm thick.

The excimer laser available for use includes, for example, the INDEX200 Series of industrial-size excimer lasers manufactured by SUMITOMO HEAVY INDUSTRIES LTD.

Next, an explanation will be made of the photochemical reaction between the light applied with the excimer laser 1 and the polyimide insulation layer 121. This photochemical reaction is explained in *Science of Materials*, 26(3):115-121, Materials Science Society of Japan, July 1989. The content of this literature may be summarized as follows:

When a polymer surface is irradiated with high-intensity, short-pulse UV rays, the irradiated portion is momentarily decomposed and flies. At this moment plasma emission and impulsive sound are involved. This phenomenon is called ablative photodecomposition (APD). The cause of APD is presumed to be that the chemical species activated to an electronic excitation state by UV rays fails to transfer energy to the surrounding molecules. The reason for the failure of energy transfer is the high density of the chemical species in the electronic excitation state which are generated in the UV rays-irradiated portion. ADP occurs only when irradiation is performed with high intensity UV laser such as KrF excimer laser, etc. This phenomenon cannot be caused with light from a low-power density light source, such as a mercury lamp. Characteristic aspects of ADP include the fact that it removes only the irradiated portion without causing thermal damage and distortion to, and without leaving burns in, the surroundings. ADP cannot be brought about unless the concentration of the exited species exceeds a critical level. In other words, there exists a threshold value for fluence (energy per unit area). When polymer is irradiated with excimer laser, the threshold value is some 10 mJ/cm²/pulse. Generally, the greater the absorption cross section of the polymer is, the lower the threshold value is. The depth of removal may be controlled by varying the fluence and the pulse number. Polymers under investigation relative to APD include polyimide, polymethyl methacrylate, polyethylene terephthalate, polystyrene, polyethylene, polycarbonate, polypropylene, polytetrafluoroethylene, nylon 66, polyacethylene, polysilane, cellulose nitrate, polydimethylglutarimide, polysiloxane, diazo type photoresist and polymethyl isopropenyl ketone.

Next, an explanation will be given with regard to the difference of the block delamination process of the present step from the prior art. In the present step, since the quartz glass board 111 is delaminated by ADP, the delamination process affects only the irradiated portion. Accordingly, the first block 100 does not deteriorate in this delamination step. The first block 100 is not heated to high temperatures. Therefore, no thermal stress can damage the block 100.

### Step 15

Referring to Fig. 16, in Step 15, the excimer laser 1 is moved. More specifically, in order to delaminate all the adhesive surfaces from the quartz glass board 111 and the polyimide insulation layer 121, the excimer laser 1 is moved so that the entire surface of the quartz glass board 111 is scanned.

### Step 16

Referring to 17, in Step 16, the quartz glass board 111 is removed from the polyimide insulation layer 121.

### Step E

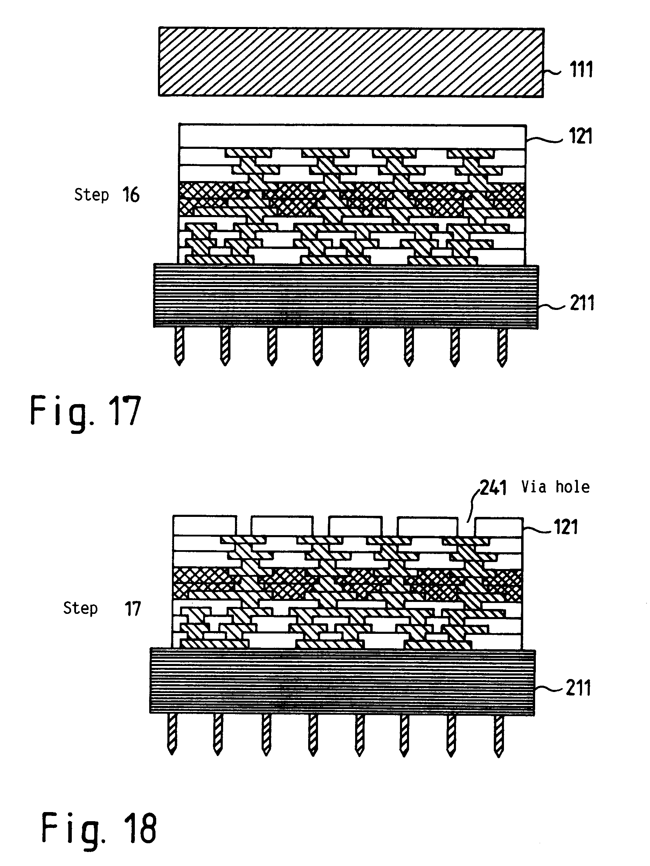

Referring to Figs. 18-20, in Steps 17-19, on the surface of the first block 100 there are formed a bump 126 and a via hole 1242.

### Step 17

Referring to 18, in Step 18, in the polyimide insulation layer 121 there is formed a via hole 1241. The via hole 1241 is formed by dry etching process.

### Step 18

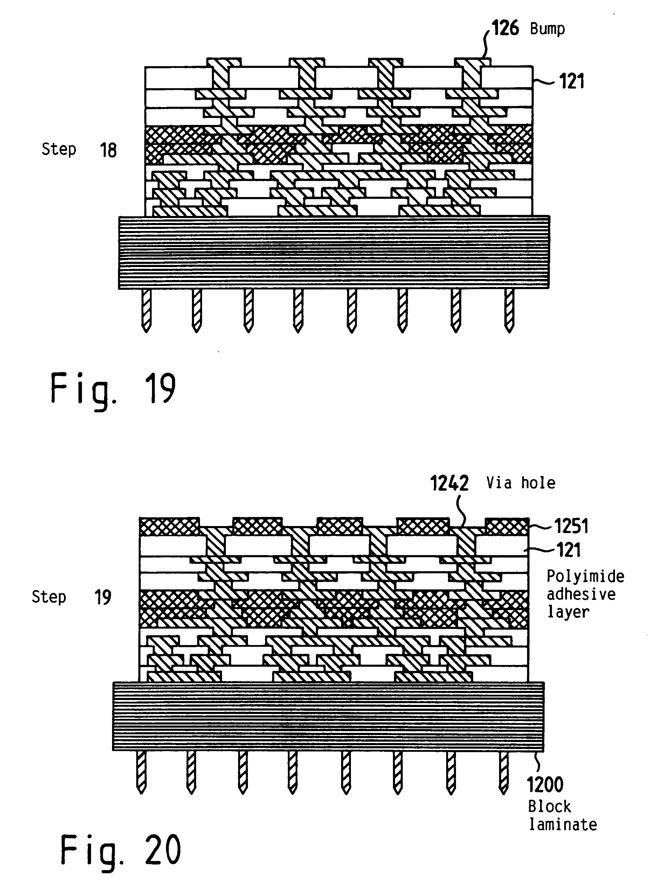

Referring to Fig. 19, in Step 19, a bump 1261 is formed on the polyimide insulation layer 121. The bump 1261 is connected with the wiring layer 131 through the via hole 1241. The via hole 1261 is formed in the same manner as in Step 6.

### Step 19

Referring to Fig. 20, in Step 20, a polyimide adhesive layer 1251 is formed on the polyimide insulation layer 121. In the polyimide adhesive layer 1251 there is formed a via hole 1242. The polyimide adhesive layer 1251 and the via hole 1241 are formed in the same manner as in Step 5.

By following Steps 13-20, a connection between the first block 100 and the second block 200 is established to form a block laminate 1200.

### Step F

In Step F, a third block 300 is formed in the same manner as the first block 100.

### Step G

### Step 20

Referring to Fig. 21, in Step 21, onto the block laminate 1200 there is connected the third block 300. The block laminate 1200 and the third block 300 are connected to each other by the same process as in Steps 13-20. Separately, the quartz glass board 311 adhering to the third block 300 is removed from the third block 300 in the same manner as in Steps 14-16. Step 13 through Step 20 are repeated until all of the predetermined number of blocks are laminated.

### Other Embodiments

The present invention may be carried out in a variety of modified ways as well as in the Example mentioned above.

First, although the delamination process utilizing a photochemical reaction (Step D) is applied to the manufacturing process for a multi-layer wiring layer in Example 1, this delamination process may be applied to steps of manufacturing other electronic parts. This delamination process may be applied to any manufacturing process comprising steps of delaminating a polymer form the block.

Second, although polyimide is employed as the organic resin in Example 1, the application of the polyimide is not limited to this case. All the products resulting from ADP may be utilized.

Third, although a quartz glass board is employed as the board, the application of the present invention is not limited to this case. Any board may be used as long as it transmits the irradiation.

Fourth, although gold is used as the wiring material in Example 1, a low resistance metal such as copper may be used instead.

Fifth, although a ceramic board 211 is used as the board for the second block 200 in Example 1, any rigid organic resin board may be used instead of the ceramic board 211. Illustrative examples of the rigid organic resin board include a polyimide resin-molded board. In the case of polyimide resin-molded boards, a pin 212 is attached by hitting the pin 212 into a through-hole formed in the board.

If a polyimide resin-molded board is used as the board for the second block 200, then the coefficient of thermal expansion of the second block 200 to be layered thereon may be the same as the coefficient of thermal expansion of the board. With the same coefficients of thermal expansion, damage due to thermal stress may be prevented. Therefore, it is suitable for use in the manufacturing of large-area, multi-layer wiring boards which have been associated with serious thermal stress problems.

As mentioned above, in Example 1, the photochemical reaction between the excimer laser and the organic resin insulation layer serves to delaminate the organic resin multi-layer wiring layer from the board. For this reason, there is no degradation of the organic resin multi-layer wiring layer during the delamination process. In other words, according to Example 1, it is possible to manufacture an organic resin multi-layer wiring layer with a high degree of reliability.

### Example 2

Next, an explanation will be given regarding Example 2 of the present invention with reference to the drawings.

The purpose of Example 2 is to form a organic resin multi-layer wiring layer with a higher degree of reliability than in Example 1. In order to accomplish this purpose, in Example 2, prior to connecting between the first block 100 and the second block 200 the quartz glass board 111 is removed.

Referring to Fig. 22, according to the manufacturing process of Example 2, Step H is added to the respective steps of Example 1 shown in Fig. 1. Step H is carried out immediately after Steps A and B. Step C and Step D are performed in reverse order compared to Example 1. Steps A, B, C, D, E, F and G are the same as those of Example 1 shown in Fig. 1. Therefore, for the details of these steps, reference should be made to the description of Example 1.

Details of Step H are as follows:

### Step H

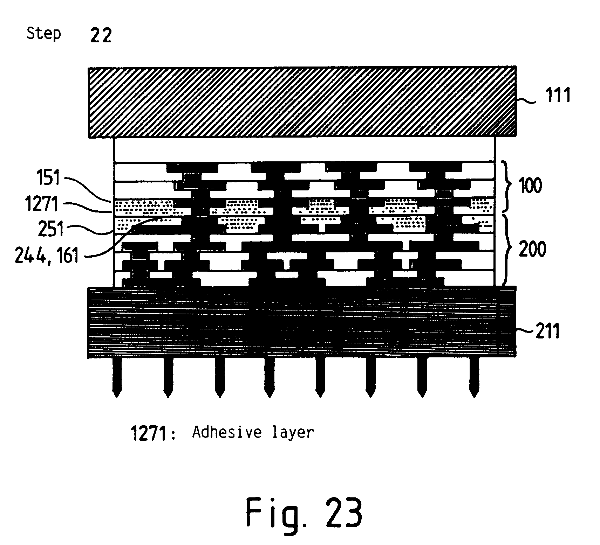

Referring to Fig. 23, in Step 22, a first block 100 is temporarily stuck on a second block 200 by an adhesive layer 1271. More concretely, a polyimide adhesive layer 151 and a polyimide adhesive layer 251 are stuck temporarily. The first block 100 and the second block 200 are the ones manufactured in Steps A and B, respectively.

The temporary adhesion of the first block 100 is accomplished in the following steps:

In the first step, on the uppermost layer of the second block 200 there is provided an adhesive layer 1271. The adhesive is applyed by a dispensor. The adhesive layer 1271 is prepared by application of an adhesive. Alternatively, a adhesive sheet may form the adhesive layer 1271.

In the present example, the adhesive layer 1271 is provided on the uppermost layer of the second block 200, nevertheless, it may be positioned on the uppermost layer of the first block 100. Further, both the first block 100 and the second block 200 may be equipped therewith.

In the second step, positioning of the first block 100 is performed. That is, the fist block 100 is positioned so that the bump 161 of the first block 100 is inserted in the counterpart via hole 244 of the second block 200.

In the third step, the first block 100 is mounted on the second block 200.

The adhesive layer 1271 corrects between Steps D and C, ad between the first block 100 and the second block 200. Therefore, Steps D and C may be carried out under entirely the same conditions as in Example 1.

As a result of heating in Step C, the adhesion layer 1271 is burnt off. After the adhesive layer 1271 has been burnt off, the polyimide adhesive layer 151 and the polyimide adhesive layer 251 adhere to each other, and further the bump 161 melts to connect with the wiring layer 234. As a result, there is produced the same block laminate 1200 as that in Example 1.

Hereunder, an explanation will be given of the difference in effects between Example 1 and Example 2.

The polyimide layers composing the first block 100 and the quartz glass board 111 have coefficients of thermal expansion which differ from each other by about one order of magnitude. For this reason, if heating is performed while leaving the quartz glass board 111 as in Example 1, then the first block 100 may be damaged due to thermal stress.

Actually, however, in Example 2, the quartz glass board 111 is removed in this step. Therefore, in the next heating and pressing step, the first block 100 cannot be damaged due to thermal stress.

### Example 3

Next, Example 3 of the present invention will be explained. Example 3 has four characteristic aspects not shared by Example 1 and Example 2. A first characteristic aspect is the formation of a via hole by excimer laser irradiation. A second characteristic aspect resides in a fact that a step which corresponds to Step E of Example 1 may be omitted. A third characteristic aspect is the simultaneous manufacturing of a plurality of blocks in one manufacturing apparatus. A fourth characteristic aspect is the formation of an alignment mark. Here, the "alignment mark" is a mark which facilitates correction of positional and angular displacements when blocks are layered. The alignment mark is formed at the same time the metal patterns such as signal patterns are formed.

### Step 1

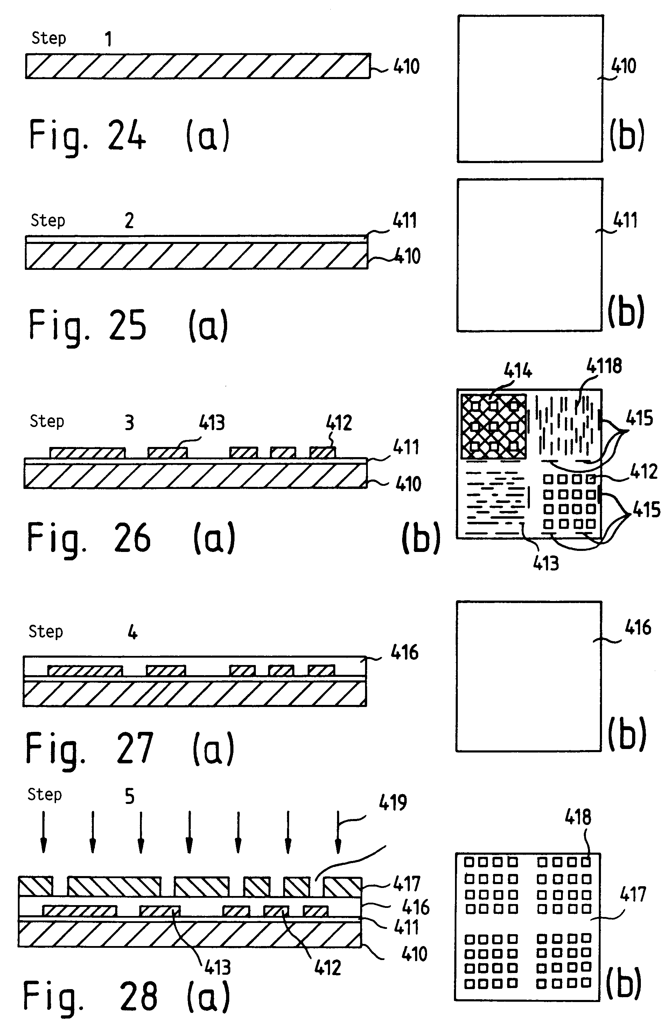

Referring to Figs. 24(a) and (b), in Step 1, a quartz glass board 410 is prepared. The board has a size of 210 mm x 210 mm.

### Step 2

Referring to Figs. 25(a) and (b), in Step 2, on the quartz glass board 410 is formed a polyimide resin layer 411. The thickness of the polyimide resin layer 411 is 0.2 µm. When delaminating the quartz glass board 410, the polyimide layer 411 is etched and completely removed. Therefore, the polyimide layer 411 may be thin. The polyimide layer 411 is formed by precuring and curing a polyimide precursor applied on the quartz glass board 410.

### Step 3

Referring to Figs. 26(a) and (b), in Step 3, on the polyimide resin layer 411 are formed four types of metal patterns. The four types of metal patterns include a pad 412 for carrying LSI, a first signal wiring pattern 413, a second signal wiring pattern 4118 and power/ground pattern 414.

The metal patterns are formed by electroplating conductor patterns. The conductor patterns are formed by photolithographic techniques using a photoresist. The metal deposit consists of three skins. The materials of the first through third metal skins are gold, nickel and gold, respectively. The first metal skin is located closest to the polyimide resin layer 411. The first through third metal skins are 4 µm, 2 µm and 4 µmm thick, respectively.

The third metal skin melts with part of the bump 4111 in the later heating step. The second metal skin prevents the molten bump 4111 from diffusing into the first metal skin.

In Step 3, also an alignment mark 415 is formed. Part of the metal patterns forms the alignment mark 415. This alignment mark 415 serves as a guide for correction of the positional and angular displacements of the respective blocks when the blocks are layered. The alignment mark 415 is composed of two lateral lines and one longitudinal line. One lateral line and one longitudinal line are used for positioning with respect to the X axis and Y axis. The other lateral line is used for adjusting the angle between the blocks. The lateral line is used for the positioning, while the longitudinal line is used for adjustment of the angles. The alignment mark 415 is see-through when viewed from over the polyimide adhesive layer 416 to be layered later.

### Step 4

Referring to Figs. 27(a) and (b), in Step 4, a polyimide adhesive layer 416 is applied onto the metal patterns. Upon completion of application, the polyimide adhesive layer 416 undergoes baking and curing. The thickness of the polyimide adhesive layer 416 attains 10 µm after curing.

### Step 5

Referring to Fig. 28, a via hole 4110 is formed in the polyimide adhesive layer 416 by photolithographic techniques. Step 5 includes the following two steps:

In the first step, on the polyimide adhesive layer 416 is applied a photoresist 417. The photoresist 416 is 20 µm thick. Since the photoresist 417 is more readily removed than the polyimide adhesive layer 416, the photoresist 417 must be about twice as thick as the polyimide adhesive layer 416.

In the second step, UV excimer laser 419 irradiation is performed. The excimer laser 419 is KrF excimer laser. Oscillation number and energy density of the UV light is 200 Hz and 0.8 J/cm², respectively. UV irradiation is performed 200 shots per spot. After 200 shots of irradiation, UV irradiation is again performed an additional 200 shots on the sifted irradiation spots. The excimer laser 419 is used for raster scanning of the entire photoresist 417.

The UV irradiation causes a photochemical reaction of the polyimide adhesive layer 416. This photochemical reaction is the same as in Example 1. As a result of the photochemical reaction, the portion of the polyimide adhesive layer 416 which is not covered with the photoresist 417 is removed. This portion forms a via hole 4110. The metal patterns are bare in the via hole 4110.

### Step 6

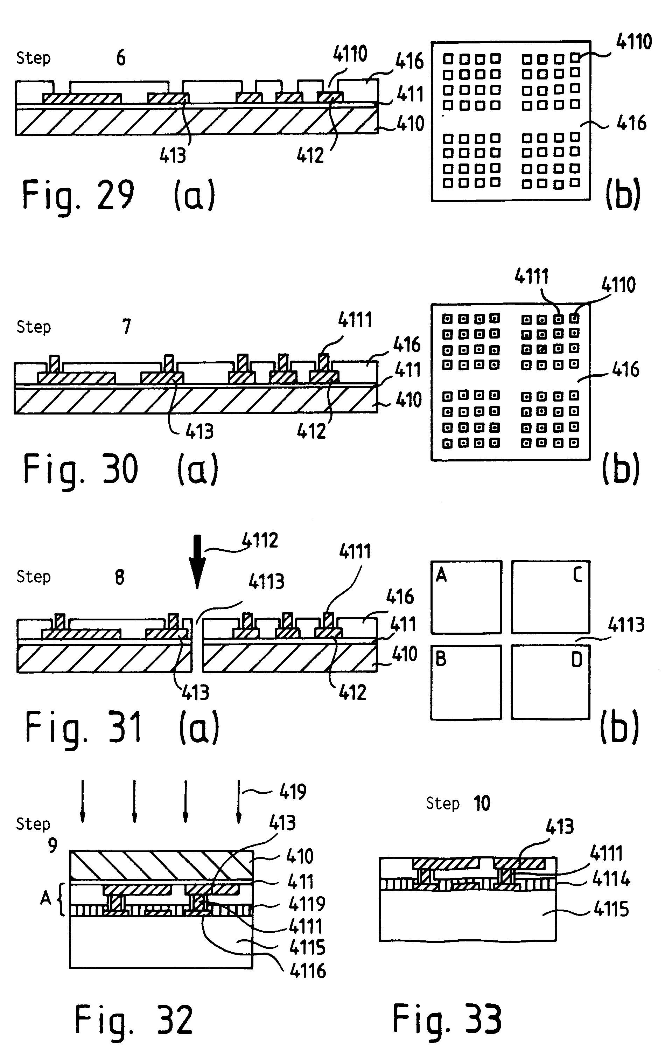

Referring to Fig. 29, in Step 6, the photoresist 417 is removed by methyl ethyl ketone. Thereafter, soot in the via hole 4110 of the polyimide adhesive layer 416 is removed by oxygen plasma ashing. The via hole has a diameter of 150 µm.

### Step 7

Referring to Fig. 30, in Step 7, on the metal patterns in the via hole 4110 there is formed a bump 4111. The bump 4111 is formed by metal plating. The metal deposit consists of four skins. The materials of the first through fourth skins are nickel, gold, tin and gold, respectively. The first skin is located closest to the metal patterns. The first through fourth metal skins are 3 µm, 8 µm, 11 µm and 8 µm, respectively. The diameter of the bump 4111 is 100 µm. The weight ratio of the gold to tin is gold : tin = 4 : 1. During the later heating process, the second through fourth skins melt and mingle with the metal patterns. The first skin prevents the mixture of the second through fourth skins from diffusing into the metal patterns.

### Step 8

Referring to Fig. 31, in Step 8, the quartz glass board 410 is divided into four segments by a blade 4112. The blade 4112 is the edge of a dicing saw.

The four segments are called Blocks A through D, respectively. Block A comprises a power/ground pattern 414. Block B comprises a first signal wiring pattern 413. Block C comprises a second signal wiring pattern 4118. Block D comprises a pad 412 for carrying LSI.

### Step 9

Referring to Fig. 32, in Step 9, Block A is temporarily stuck on the multi-layer wiring board 4115. After completion of temporary sticking, Block A is irradiated with UV excimer laser 419. The multi-layer wiring board 4115 comprises a conductor layer inside and a power supply layer and ground wiring layer on the surface.

Step 9 includes the following four steps:

In the firststep, an adhesive 4114 is sprayed over the entire surface of the multi-layer wiring board 4115. In detail, adhesive 4114 consists of two layers. The lower layer is made of an adhesive of polyimide. The upper layer is made of an adhesive which burns off during the sintering. Both of the layer of the adhesive are provided by spryaing.

In the second step, Block A is mounted on the multi-layer wiring board 4115. At the same time, positioning of Block A is carried out using the alignment mark as the guide.

In the third step, Block A is pressed. The pressure is 1 kg/cm². The pressing time is some two minutes.

In the fourth step, Block A is irradiated with UV excimer laser 419. The properties of the excimer laser 419 are the same as in Step 5. The UV rays are transmitted through the quartz glass board 410 and reaches the polyimide resin layer 411. Upon UV irradiation, the polyimide resin layer 411 of Block A is removed. The excimer laser 419 unit is moved so that the entire surface of the polyimide resin layer 411 is subjected to raster scanning with UV rays. By removal of the polyimide resin layer 411, Block A is delaminated from the quartz glass board 410.

The number of shots of UV irradiation is controlled depending on the thickness of the polyimide resin layer 411. If the number of shots is small, then traces of the polyimide resin 411 are found. If the number of shots is large, then even the polyimide adhesive layer 416 is removed. In the present example where the polyimide resin layer 411 is 0.2 µm thick, an optimum number of shots is two per spot.

### Step 10

Referring to Fig. 33, in Step 10, soot on Block A is removed by oxygen plasma ashing. Upon removal of the soot, the metal patterns are exposed.

### Step 11

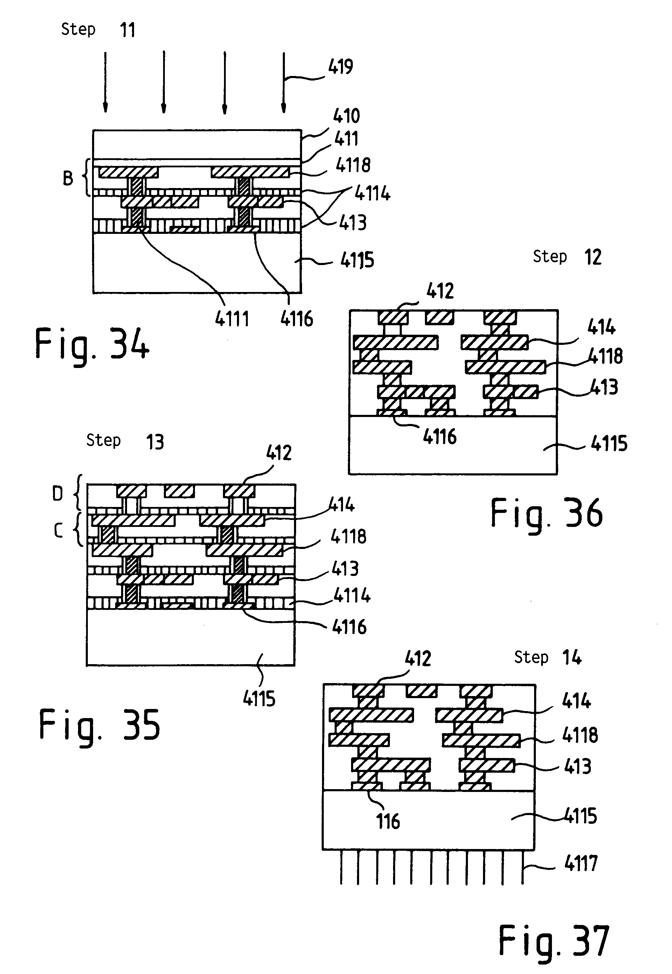

Referring to Fig. 34, in Step 11, Block B is temporarily stuck on Block A in the same manner as in Step 9. After completion of temporary sticking, the quartz glass board 410 is removed from Block B.

### Step 12

Referring to Fig. 35, in Step 12, Block C is layered on Block B in the same manner as in Step 9. Upon completion of layering of Block C, Block D is layered on Block C in the same manner as in Step 9.

### Step 13

Referring to Fig. 36, in Step 13, Blocks A-D are connected.

The connections between the blocks are established by pressing and heating Blocks A-D. The temperature is 350°C, while the pressure is 20 kg/cm². Pressing and heating are conducted for 30 minutes.

Upon heating and pressing, the adhesive 4114 is burnt off. The polyimide adhesive layers 416 acquire fluidity. The polyimide adhesive layers 416 which have acquired fluidity are combined into one to establish firm connections between the blocks. In this manner, mechanical connections are established between the blocks.

When heated and pressed, the second through fourth skins of the bump 411 melt. The melting temperature is 280°C, the eutectic point of gold and tin. The molten bump 111 mingles with the metal patterns of the neighboring blocks. This achieves electric connections between the blocks.

### Step 14

Referring to Fig. 37, in Step 14, an I/O pin 4117 is integrated into the multi-layer wiring board 4115. The I/O pin 4117 electrically connects with the metal patterns of the respective blocks.

As mentioned above, in Example 3, the via hole 4110 is formed by irradiation with UV excimer laser 419 in Steps 5 and 6.

In Example 3, the UV rays completely remove the polyimide resin layer 411 and expose the metal patterns in Steps 9 and 10. Accordingly, different form Example 1, there is no need to form a via hole in the uppermost block after completion of connections between the blocks. More specifically, Example 3 does not need any step equivalent to Step E of Example 1.

In Example 3, four blocks are formed on one quartz glass board 410 simultaneously. That is, one manufacturing apparatus manufactures four blocks concurrently. This means that the organic resin multi-layer wiring boards may be manufactured in a short time.

In Example 3, the alignment pattern 415 is formed as part of the metal patterns. For this reason, positioning of the blocks is facilitated.

### Example 4

Next, Example 4 of the present invention will be explained with reference to the drawings.

Characteristic aspects of Example 4 include the fact that a plurality of the same type of blocks are formed on one quartz glass board. For instance, four Blocks A are formed on the first quartz glass board. Similarly, four each of Blocks B-C are formed on the second through fourth quartz glass boards. By connecting Blocks A-D formed in this manner, four organic resin multi-layer wiring boards are formed.

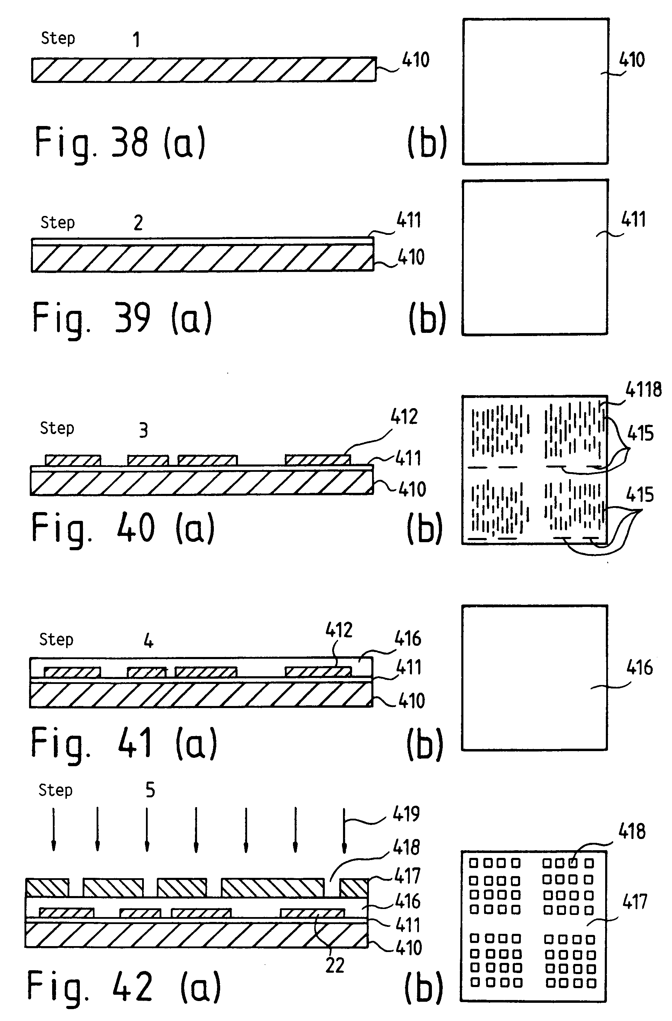

Referring to Figs. 38-50, the manufacturing process of Example 4 consists of Steps 1-8 and the subsequent Steps 15-19.

### Steps 1-8

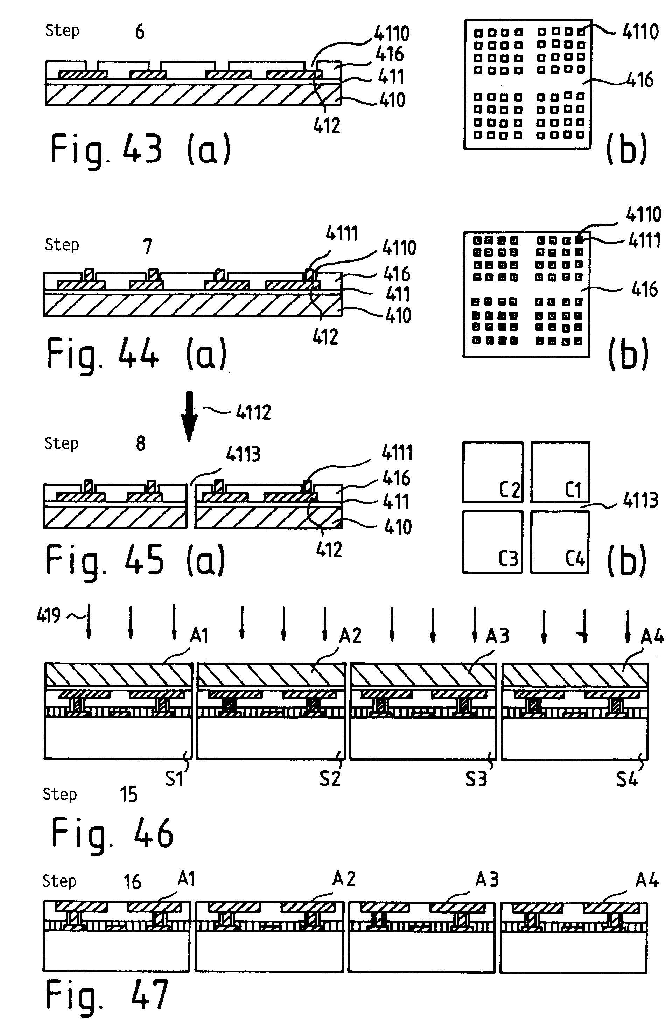

Referring to Figs. 38-45, Steps 1-8 of Example 4 are the same as in Example 3. However, in Step 3, four identical metal patterns are formed on the polyimide resin layer 411. In Fig. 40, four second signal wiring layer 4118 are formed. Referring to Fig. 45, all the four Blocks C1-C4 to be formed in Step B are the same as Block C in Example 3.

### Step 15

In the same manner as in Steps 1-8, from other three quartz glass boards 410 ,there are formed Blocks A1-A4, B1-B4 and D1-D4.

Referring to Fig. 46, in Step 15, Blocks A1-A4 are stuck on multi-layer wiring boards S1-S4. After ensuring sticking, the quartz glass board 410 is delaminated from Blocks A1-A4. The sticking method and the method of delaminating the quartz glass board are the same as in Step 9 of Example 3.

### Step 16

Referring to Fig. 47, in Step 16, soot on the surfaces of Blocks A1-A4 is removed in the same manner as in Step 10 of Example 3.

### Step 17

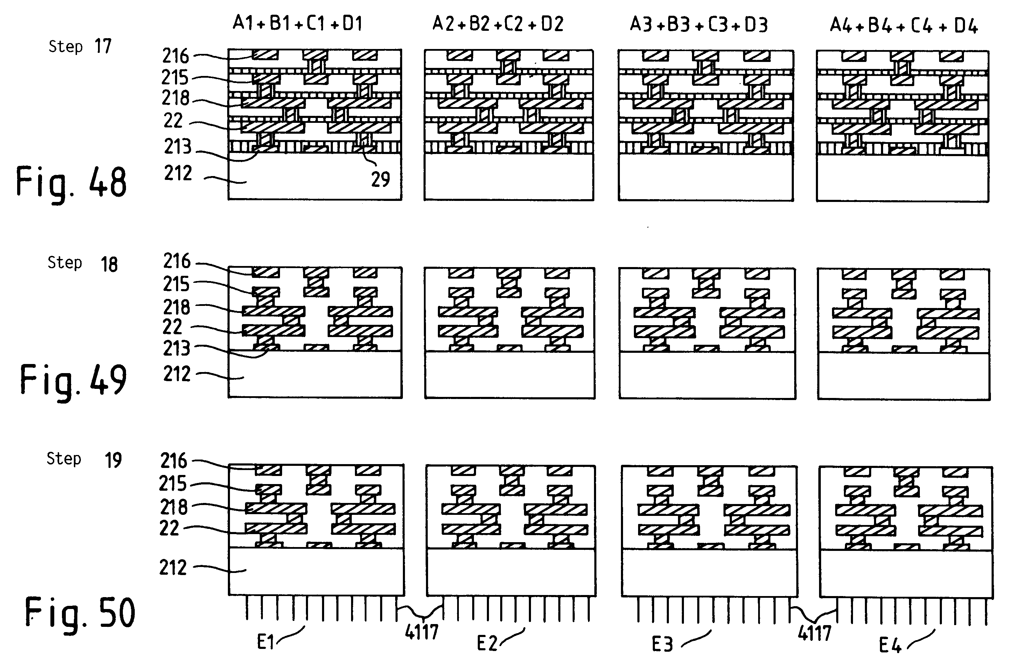

Referring to Fig. 48, in Step 17, Blocks B1-B4 are stuck on Blocks A1-A4 in the same manner as in Steps 15 and 16. After ensuring sticking of Blocks B1-B4, Blocks C1-C4 are stuck on B1-B4, respectively. After sticking of Blocks C1-C4, Blocks D1-D4 are stuck on Blocks C1-C4, respectively.

### Step 18

Referring to Fig. 49, in Step 18, Blocks A1-D1, A2-D2, A3-D3 and A4-D4 are connected in the same manner as in Step 13 of Example 3.

### Step 19

Referring to Fig. 50, in Step 19, an I/O pin 4117 is integrated into the multi-layer wiring boards S1-S4 in the same manner as in Step 14 of Example 3. As a result, organic resin multi-layer wiring boards E1-E4 are formed. The organic resin multi-layer wiring board E1 comprises Blocks Ai-Di.

As mentioned above, in Example 4, a plurality of identical metal patters are formed on one quartz glass board, and identical blocks are manufactured simultaneously by dividing the resulting composite.

As this invention may be embodied in several forms without departing from the spirit of essential characteristics thereof, the present embodiment is therefore illustrative and not restrictive, since the scope of the invention is defined by the appended claims rather than by the description preceding them, and all changes that fall within meets and bounds of the claims, or equivalence of such meets and bounds are therefore intended to embraced by the claims.

## Claims

1. A process for delaminating an organic resin from a board, comprising steps of:
(A) providing a first surface of a board with an organic resin layer, wherein said organic resin is capable of undergoing a photochemical reaction by exposure to light, and the board is capable of transmitting light; and
(B) applying light to a second surface of said board, wherein said light is transmitted through said board and reaches said organic resin to cause the section of said organic resin which contacts with said board to undergo said photochemical reaction by exposure to said light, thereby lowering the adhesive force between said organic resin and said board.

2. A process for delaminating an organic resin from a board as claimed in Claim 1, wherein said photochemical reaction decomposes said organic resin layer.

3. A process for delaminating an organic resin from a board as claimed in Claim 2, wherein said photochemical reaction causes ablative photodecomposition.

4. A process for delaminating an organic resin from a board as claimed in Claim 3, wherein said light is UV light.

5. A process as claimed in any of claims 1 to 4, wherein said UV light is irradiated with a excimer laser.

6. A process as claimed in claims 1 to 5, wherein said board comprises quartz glass.

7. A process as claimed in claims 1 to 6, wherein said organic resin layer comprises a photosensitive polyimide.

8. A process for manufacturing an organic resin multi-layer wiring board by connecting a first block with a second block, comprising steps of:
(A) forming a first block on a first board, wherein said first board is capable of transmitting light, and comprising the following steps of:
(a) forming a first organic resin layer on said board, wherein said first organic resin layer is capable of undergoing a photochemical reaction by exposure to light;
(b) alternatively laminating a wiring layer and an organic resin insulation layer on said first organic resin layer; and
(c) laminating a first organic resin adhesive layer on said organic resin insulation layer or said wiring layer arranged in said Step (b);
(B) forming a second block on a second board, and comprising the following steps of:
(d) alternatively laminating an organic resin insulation layer and a wiring layer on a second board; and
(e) laminating a second organic resin adhesive layer on said organic resin insulation layer or said wiring layer formed in said Step (d);
(C) connecting said first block with said second block and comprising the following steps of:
(f) facing said first organic resin adhesive layer of said first block to said second organic resin adhesive layer of said second block; and
(g) heating and pressing said first block and said second block to stick said first organic resin adhesive layer to said second organic resin adhesive layer; and
(D) delaminating said first block from said first board and comprising the following steps of:
(h) irradiating the opposite side from the side of said first board which has said first organic resin layer, with said light which is transmitted through said first board and reaches said first organic resin layer to cause the section of said organic resin layer which adheres to said first board to undergo a photochemical reaction by exposure to said light, thereby lowering the adhesive force between said first organic resin layer and said first board; and
(i) delaminating said first block from said first board.

9. A process for manufacturing an organic resin multi-layer wiring board as claimed in Claim 8,
wherein a bump is formed on the surface of at least one of said first block and said second block; and
in said Step (g) the wiring layer of said first block and the wiring layer of said second block are connected electrically through said bump.

10. A process as claimed in claim 8 or 9, wherein said first board comprises quartz glass.

11. A process as claimed in claim 8, 9 or 10, wherein said second board is a ceramic board.

12. A process as claimed in any of claims 8 to 11, wherein said second substrate comprises a polyimide resin.

13. A process as claimed in any of claims 8 to 12, wherein said first organic resin layer comprises a photosensitive polyimide.

14. A process as claimed in any one of claims 8 to 13, wherein said light in said Step 7 is UV light.

15. A process for manufacturing an organic resin multi-layer wiring board as claimed in Claim 14, wherein said UV light is irradiated with an excimer laser.

16. A process as claimed in any one of claims 8 to 15, wherein in said Step D delamination of said first board exposes the wiring layer of said first block.

17. A process as claimed in claims 8 to 16, wherein at least one of said Step (b) and said Step (e) comprises the following steps of: (j) laminating said first organic resin insulation layer on the wiring layer, wherein said first organic resin insulation layer is removed by irradiation with a second light;
(k) applying a photoresist on said first organic resin insulation layer; and
(l) irradiating said photoresist with said second light to remove the section of said first organic resin insulation layer which is not covered with said photoresist.

18. A process as claimed in any one of claims 8 to 17, wherein in at least one of said Step (b) and said Step (e) an alignment mark is formed in at least one of said first block and said second block.

19. A process as claimed in any one of claims 8 to 18, wherein in said Steps (A) and (B) said first block and said third block are formed on a third board, said third board is divided into a plurality of segments one of which is said first board, and one of the remaining ones of which is said second substrate.

20. A process as claimed in any one of claims 8 to 19. wherein said Step (C) is carried out after said Step (D), and after said Step (B) said first organic resin adhesive layer of said first block and said second organic resin adhesive layer of said second block are stuck to each other with an adhesive.

21. A process for manufacturing an organic resin multi-layer wiring board by connecting a first block with a second block, comprising steps of:
(A) forming a first block on a first board, wherein said first board is capable of transmitting light, and comprising the following steps of:
(a) forming a first organic resin layer on said board, wherein said first organic resin layer is capable of undergoing a photochemical reaction by exposure to light;
(b) alternatively laminating a wiring layer and an organic resin insulation layer on said first organic resin layer; and
(c) laminating another first organic resin adhesive layer on said organic resin insulation layer or said wiring layer arranged in said Step (b);
(B) forming a second block on a second board, and comprising the following steps of:
(d) alternatively laminating an organic resin insulation layer and a wiring layer on a second board; and
(e) laminating a second organic resin adhesive layer on said organic resin insulation layer or said wiring layer formed in said Step (d);
(C) sticking said first organic resin adhesive layer of said first block to said second organic resin adhesive layer of said second block with an adhesive;
(D) delaminating said first block from said first board and comprising the following steps of:
(f) irradiating the opposite side from the side of said first board which has said first organic resin layer, with said light which is transmitted through said first board and reaches said first organic resin layer to cause the section of said organic resin layer which adheres to said first board to undergo a photochemical reaction by exposure to said light, thereby lowering the adhesive force between said first organic resin layer and said first board; and
(g) delaminating said first block from said first board; and
(E) connecting said first block with said second bock and comprising the following steps of:
(h) facing said first organic resin adhesive layer of said first block to said second organic resin adhesive layer of said second block; and
(i) heating and pressing said first block and said second block to stick said first organic resin adhesive layer to said second organic resin adhesive layer.

22. A process for manufacturing an organic resin multi-layer wiring board as claimed in Claim 21, wherein in Said D delamination of said first board exposes the wiring layer of said first block.

23. A process as claimed in claim 21 or 22, wherein at least one of said Step (b) and said Step (e) comprises the following steps of:
(j) laminating said first organic resin insulation layer on the wiring layer, wherein said first organic resin insulation layer is removed by irradiation with a second light;
(k) applying a photoresist on said first organic resin insulation layer; and
(l) irradiating said photoresist with said second light to remove the section of said organic resin insulation layer which is not covered with said photoresist.

24. A process as claimed in claim 21, 22 or 23, wherein in at least one of said Step (b) and said Step (e) an alignment mark is formed in at least one of said first block and said second block.

25. A process as claimed in any one of claims 21 to 24, wherein in said Steps (A) and (B) said first block and said third block are formed on a third board, said third board is divided into a plurality of segments one of which is said first board, and one of the remaining ones of which is said second substrate.

26. A process for manufacturing a multi-layer wiring board by connecting a plurality of blocks, which comprises the following steps of:
(A) forming a plurality of multi-layer wiring layers on a first board; and
(B) dividing said multi-layer wiring layer into a plurality of segments which form a plurality of blocks.

27. A multi-layer wiring board producible with the process of any one of claims 8 to 26.
